# EUROPEAN PATENT APPLICATION

(11) **EP 4 797 295 A2**
(43) Date of publication of application: **26.08.2026**
(21) Application number: 25224414.0
(22) Date of filing: 17.12.2025
(51) Int. Cl.: H01F 27/28, H01F 27/29, H01F 38/14, H05K 1/18

(54) **WIRELESS TRANSMISSION MODULE**

(30) Priority: 24.02.2025 CN 202510202565
(71) Applicant: TDK Corporation, Tokyo 103-6128 (JP)
(72) Inventor: CHEN, Mao-Chun, 326 Taoyuan City (TW); YU, Tai-Hsien, 326 Taoyuan City (TW); LEE, Kuo-Jui, 326 Taoyuan City (TW); LI, Wei-Chun, 326 Taoyuan City (TW)
(74) Representative: Epping - Hermann - Fischer

(57) **Abstract**

A wireless transmission module for transmitting energy or signals includes a coil assembly and a first base. The coil assembly has a winding axis. The first base corresponds to the coil assembly. The coil assembly and the first base are arranged along the winding axis. The wireless transmission module further includes a second base, the coil assembly and the first base are disposed on a first side plate of the second base, and a plurality of electronic components are disposed on a second side plate of the second base.

## Description

### CROSS REFERENCE TO RELATED APPLICATIONS

This application claims the benefit of China Patent Application No. 202510202565.6, filed on February 24, 2025, the entirety of which is incorporated by reference herein.

### TECHNICAL FIELD

The present disclosure relates to a wireless transmission module, and more particularly it relates to a wireless transmission module applied to wireless communication or wireless charging.

### BACKBGOUND

As technology has progressed, many kinds of electronic devices such as tablet computers and smartphones have begun to include the functionality of wireless charging. A user can place an electronic device on a wireless charging transmitting terminal, so that the wireless charging receiving terminal inside the electronic device generates current by electromagnetic induction or electromagnetic resonance to charge the battery. Due to the convenience of wireless charging, electronic devices equipped with wireless charging modules have gradually become popular.

In general, a wireless charging device includes a magnetic conductive plate to support a coil. When the coil is provided with electricity to operate in a wireless charging mode or a wireless communication mode, the magnetic conductive plate can concentrate the magnetic lines of force emitted from the coil for better performance. However, the structure of existing wireless charging (or communication) modules and the winding configuration of their coils cannot meet various requirements for wireless devices, such as better charging performance, communication performance and less thickness.

Therefore, how to design a wireless transmission module capable of fulfilling the various needs of users is a topic nowadays that needs to be discussed and solved.

### BRIEF SUMMARY

Accordingly, one objective of the present disclosure is to provide a wireless transmission module to solve the above problems.

According to some embodiments of the disclosure, a wireless transmission module for transmitting energy or signals includes a coil assembly and a first base. The coil assembly has a winding axis. The first base corresponds to the coil assembly. The coil assembly and the first base are arranged along the winding axis.

According to some embodiments, the wireless transmission module further includes a second base which is configured to carry the coil assembly and the first base. The first base is disposed between the coil assembly and the second base. The second base has a first side plate and a second side plate. The first side plate is opposite to the second side plate. At least a portion of the coil assembly and the first base are disposed on the first side plate. The wireless transmission module further includes a plurality of electronic components which are disposed on the second side plate. The electronic components include resistors, capacitors, inductors, integrated circuit chips or a combination thereof. The electronic components do not include any coil for wireless transmission.

According to some embodiments, the second base is further provided with a first electrical contact and a second electrical contact. The coil assembly includes a winding body, a first leading wire and a second leading wire. The first leading wire and the second leading wire extend from the winding body and are configured to be connected to the first electrical contact and the second electrical contact respectively. The thickness of the coil assembly along the winding axis is less than 1 mm. The width of the first leading wire or the second leading wire is greater than 1 mm.

According to some embodiments, the second base further includes a plurality of traces. At least one of the traces is configured to be electrically connected to two of the electronic components. When viewed along the winding axis, a portion of the traces overlaps a portion of the coil assembly. The second base further includes two power input contacts, which are disposed on the second side plate. The two power input contacts are configured to be electrically connected to one of the electronic components via two of the traces.

According to some embodiments, the first side plate has an accommodating groove configured to accommodate the coil assembly and the first base. The first side plate further has a first layer and a second layer. At least a portion of the accommodating groove is located between the first layer and the second layer. The shape of the accommodating groove corresponds to the shape of the first base. The first electrical contact and the second electrical contact are located in the first side plate. When viewed along the winding axis, the second base has a rectangular structure. When viewed along the winding axis, the rectangular structure has four sides. The accommodating groove is disposed on one of the four sides.

According to some embodiments, the first electrical contact and the second electrical contact are disposed on the first layer. When viewed along the winding axis, the first electrical contact and the second electrical contact are completely shielded by the first layer. The first electrical contact and the second electrical contact are pogo pins. When viewed along the winding axis, the first leading wire and the second leading wire completely overlap the first base.

According to some embodiments, the wireless transmission module further includes a first adhesive element. The first adhesive element corresponds to the shape of the coil assembly. The winding body, the first leading wire, and the second leading wire are fixed to the first base by the first adhesive element. The coil assembly, the first adhesive element, and the first base are inserted into or withdrawn from the accommodating groove in a detachable manner.

According to some embodiments, the first electrical contact and the second electrical contact are disposed on the second layer. The second base further has an exposing opening which is formed on the first layer. When viewed along the winding axis, the first electrical contact and the second electrical contact are exposed from the exposing opening. When viewed along the winding axis, a portion of the first leading wire and the second leading wire are exposed from the exposing opening. When viewed along the winding axis, the first leading wire and the second leading wire overlap a portion of the first electrical contact and the second electrical contact, respectively.

According to some embodiments, the wireless transmission module further includes a first adhesive element, and the shape of the first adhesive element corresponds to the shape of the winding body. The winding body is fixed to the first base by the first adhesive element. When viewed along the winding axis, a portion of the first leading wire and the second leading wire does not overlap the first base.

According to some embodiments, the first side plate has an accommodating groove configured to accommodate the coil assembly and the first base. The first side plate further has a first layer and a second layer. The first layer is directly connected to the second layer. The first side plate further has a third layer and a fourth layer. The accommodating groove is formed in the first layer to the third layer. The first electrical contact and the second electrical contact are located on the fourth layer. The accommodating groove is configured to accommodate the first base, the winding body, the first electrical contact, the second electrical contact, the first leading wire and the second leading wire. When viewed along the winding axis, the second base has a rectangular structure. When viewed along the winding axis, the accommodating groove is recessed from a side surface of the rectangular structure.

According to some embodiments, the first side plate has an accommodating groove configured to accommodate the coil assembly and the first base. The first side plate further has a first layer and a second layer. The first layer is directly connected to the second layer. The accommodating groove is formed on the first layer. The shape of the accommodating groove corresponds to the shape of the first base. The first electrical contact and the second electrical contact are located on the second layer.

According to some embodiments, the accommodating groove has a first accommodating portion and a second accommodating portion. The first accommodating portion is connected to the second accommodating portion. The first accommodating portion is configured to accommodate the first base and the winding body. The second accommodating portion is configured to accommodate the first electrical contact, the second electrical contact, the first leading wire and the second leading wire.

According to some embodiments, the second base defines a first axis and a second axis. The first axis is perpendicular to the second axis. The winding axis is perpendicular to the first axis and the second axis. When viewed along the first axis, the first leading wire and the second leading wire overlap the first layer. When viewed along the second axis, the first leading wire and the second leading wire overlap the first layer.

According to some embodiments, when viewed along the winding axis, the second base has a rectangular structure. The first accommodating portion is disposed in a central region of the rectangular structure. The winding axis passes through the central region and the first accommodating portion. When viewed along the winding axis, the rectangular structure has four sides. The second accommodating portion is disposed on one of the four sides. When viewed along the winding axis, the rectangular structure has a first side. The second accommodating portion is located on the first side.

According to some embodiments, when viewed along the winding axis, the first layer has a horseshoe-shaped structure. When viewed along the winding axis, the second accommodating portion does not overlap the winding body. The first leading wire and the second leading wire extend outward from the winding body to the first electrical contact and the second electrical contact. The first accommodating portion has a first depth. The second accommodating portion has a second depth. The first depth is equal to the second depth.

The present disclosure provides a wireless transmission module, which includes a coil assembly, a first base, and a second base. The coil assembly and the first base are disposed on a first side plate of the second base, and a plurality of electronic components are disposed on a second side plate of the second base. Since all electronic components are disposed on the second side plate, the process time of the surface mounting process can be reduced by half, and it is also convenient for the operator to install the coil assembly on the first side plate, thereby increasing the convenience of assembly.

In addition, the second base may be a printed circuit board, and an accommodating groove may be formed on the first side plate. The accommodating groove is configured to accommodate the coil assembly and the first base. Based on such a configuration, the overall thickness of the wireless transmission module can be greatly reduced to achieve the purpose of thinning.

Furthermore, the coil assembly and the first base are placed into the accommodating groove or withdrawn from the accommodating groove in a detachable manner. For example, they are placed into the accommodating groove from the top surface or a side of the second base. Based on such a structural design, a damaged coil assembly can be easily replaced or a coil assembly of the same size but different function can be replaced, so that the same second base can be used, thereby achieving the purpose of reducing the overall production cost.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
FIG. 1 is a stereoscopic diagram of a wireless transmission module 10 according to an embodiment of the present disclosure;
FIG. 2 is a stereoscopic diagram of the wireless transmission module 10 in another view according to an embodiment of the present disclosure;
FIG. 3 is a three-dimensional view of a wireless transmission module 100 according to an embodiment of the present disclosure;
FIG. 4 is a bottom view of the wireless transmission module 100 according to an embodiment of the present disclosure;
FIG. 5 is a cross-sectional view of the wireless transmission module 100 along line A-A in FIG. 3 according to an embodiment of the present disclosure;
FIG. 6 is an exploded diagram of a wireless transmission module 100A according to another embodiment of the present disclosure;
FIG. 7 is a cross-sectional view of the wireless transmission module 100A along the line B-B in FIG. 6 according to another embodiment of the present disclosure;
FIG. 8 is a three-dimensional diagram of a wireless transmission module 100B according to another embodiment of the present disclosure;
FIG. 9 is a cross-sectional view of the wireless transmission module 100B along the line C-C in FIG. 8 according to another embodiment of the present disclosure;
FIG. 10 is a three-dimensional diagram of a wireless transmission module 100C according to another embodiment of the present disclosure;
FIG. 11 is a three-dimensional diagram of a wireless transmission module 100D according to another embodiment of the present disclosure; and
FIG. 12 is a cross-sectional view of the wireless transmission module 100D along the line D-D in FIG. 11 according to another embodiment of the present disclosure.

### DETAILED DESCRIPTION

The following disclosure provides many different embodiments, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include embodiments in which the first and second features are in direct contact, and may also include embodiments in which additional features may be disposed between the first and second features, such that the first and second features may not be in direct contact.

In addition, the present disclosure may repeat reference numerals and/or letters in the various examples. This repetition is for the purpose of simplicity and clarity and does not in itself dictate a relationship between the various embodiments and/or configurations discussed. Moreover, the formation of a feature on, connected to, and/or coupled to another feature in the present disclosure that follows may include embodiments in which the features are in direct contact, and may also include embodiments in which additional features may be disposed interposing the features, such that the features may not be in direct contact. In addition, spatially relative terms, for example, "vertical," "above," "over," "below,", "bottom," etc. as well as derivatives thereof (e.g., "downwardly," "upwardly," etc.) are used in the present disclosure for ease of description of one feature's relationship to another feature. The spatially relative terms are intended to cover different orientations of the device, including the features.

Unless defined otherwise, all technical and scientific terms used herein have the same meaning as commonly understood by one of ordinary skill in the art to which this disclosure belongs. It should be appreciated that each term, which is defined in a commonly used dictionary, should be interpreted as having a meaning conforming to the relative skills and the background or the context of the present disclosure, and should not be interpreted in an idealized or overly formal manner unless defined otherwise.

Use of ordinal terms such as "first", "second", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

In addition, in some embodiments of the present disclosure, terms concerning attachments, coupling and the like, such as "connected" and "interconnected", refer to a relationship wherein structures are secured or attached to one another either directly or indirectly through intervening structures, as well as both movable or rigid attachments or relationships, unless expressly described otherwise.

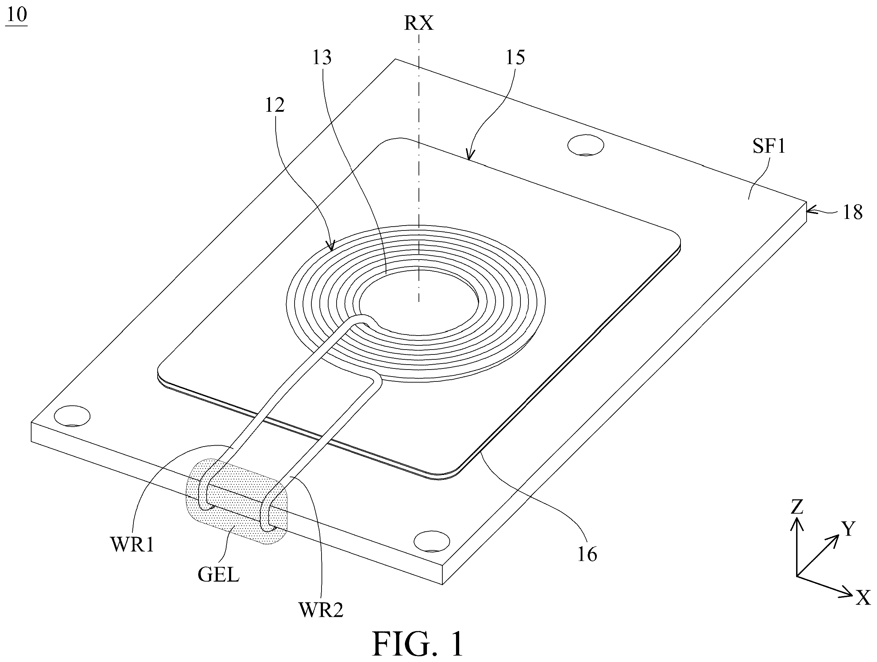

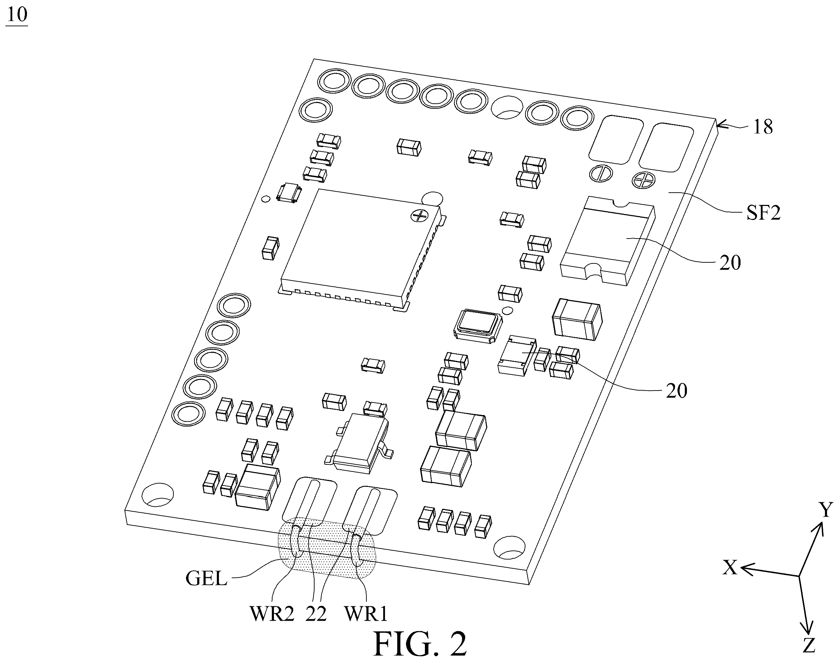

Please refer to FIG. 1 and FIG. 2, FIG. 1 is a stereoscopic diagram of a wireless transmission module 10 according to an embodiment of the present disclosure, and FIG. 2 is a stereoscopic diagram of the wireless transmission module 10 in another view according to an embodiment of the present disclosure. As shown in FIG. 1, the wireless transmission module 10 is a wireless transmission module that can be used to transmit energy or signals. In this embodiment, the wireless transmission module 10 may include a coil assembly 12, a first adhesive element 13, a magnetically permeable base 15, a second adhesive element 16, and a base plate 18.

In this embodiment, the coil assembly 12, the first adhesive element 13, the magnetically permeable base 15, the second adhesive element 16, and the base plate 18 are arranged and stacked along the extending direction of a winding axis RX of the coil assembly 12 in sequence.

Specifically, the coil assembly 12 is fixedly disposed on the magnetically permeable base 15 by the first adhesive element 13, and the magnetically permeable base 15 is fixedly disposed on the base plate 18 by the second adhesive element 16. In this embodiment, the coil assembly 12 may be a winding coil, the magnetically permeable base 15 may be a magnetic body, the first adhesive element 13 and the second adhesive element 16 may be double-sided adhesive tape or single-sided adhesive tape, and the base plate 18 may be a printed circuit board, but they are not limited thereto.

As shown in FIG. 1 and FIG. 2, the base plate 18 has a first surface SF1 and a second surface SF2, and the coil assembly 12 and the magnetically permeable base 15 are disposed on the first surface SF1. Furthermore, the wireless transmission module 10 may further include a plurality of electronic components 20 and two electrical contacts 22 which are disposed on the second surface SF2. The electronic component 20 is, for example, a capacitor, a resistor, a transistor, an integrated circuit chip, and so on.

As shown in FIG. 1 and FIG. 2, the coil assembly 12 has a first leading wire WR1 and a second leading wire WR2, which are respectively connected to the two electrical contacts 22. It is worth noting that the first leading wire WR1 and the second leading wire WR2 are extended from the first surface SF1 to the second surface SF2, and a glue GEL can be provided at the junction of the first surface SF1 and the second surface SF2 to fix the first leading wire WR1 and the second leading wire WR2.

Based on such a configuration, since all the electronic components 20 are disposed on the second surface SF2, it is not necessary to perform the surface mount technology (SMT) process on both surfaces, thereby reducing the process time of the surface mount technology by half, and it is also convenient for the operator to install the coil assembly 12 on the first surface SF1, thereby increasing the convenience of assembly.

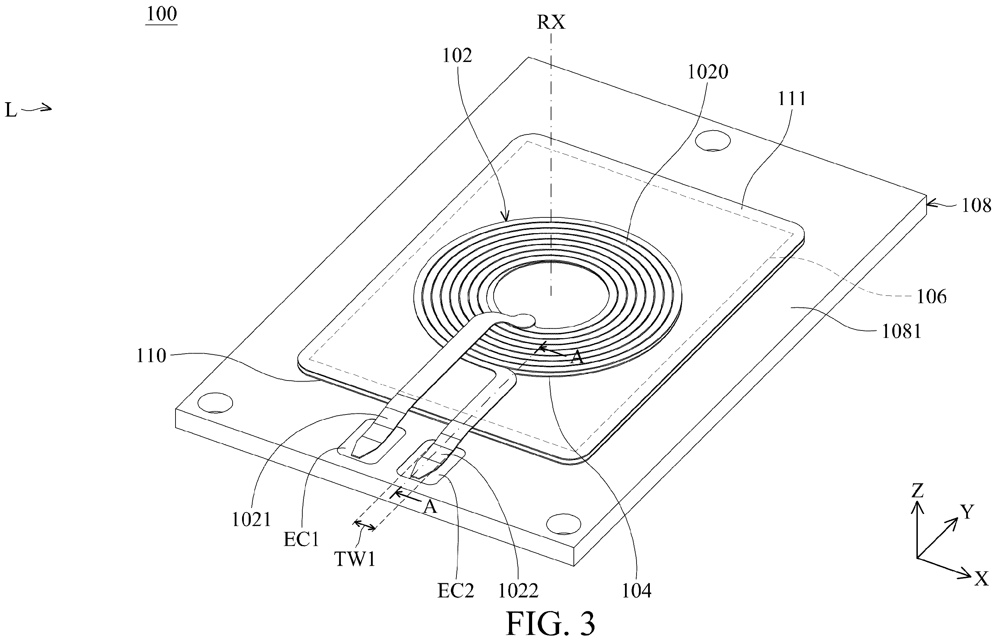

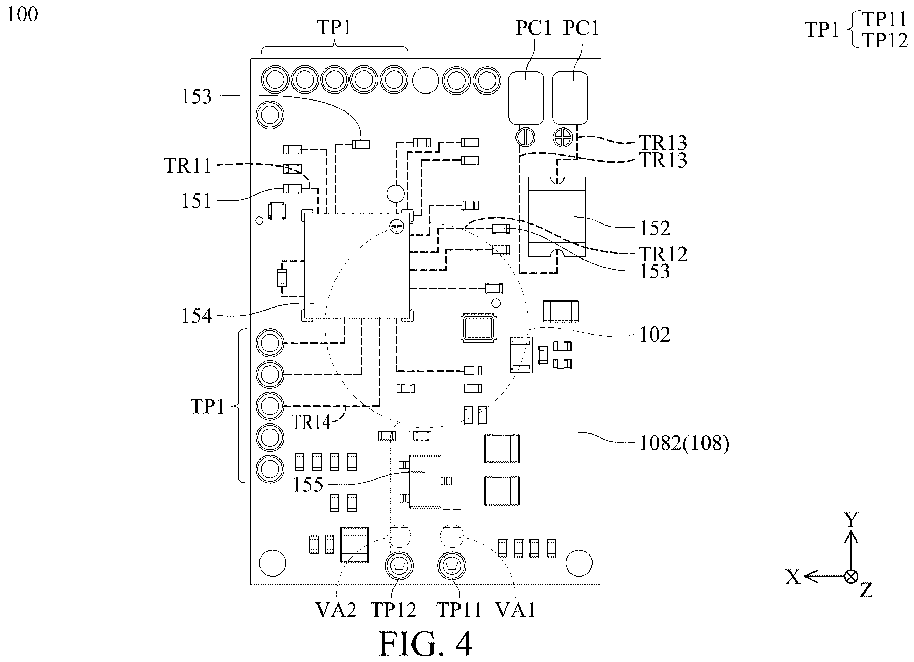

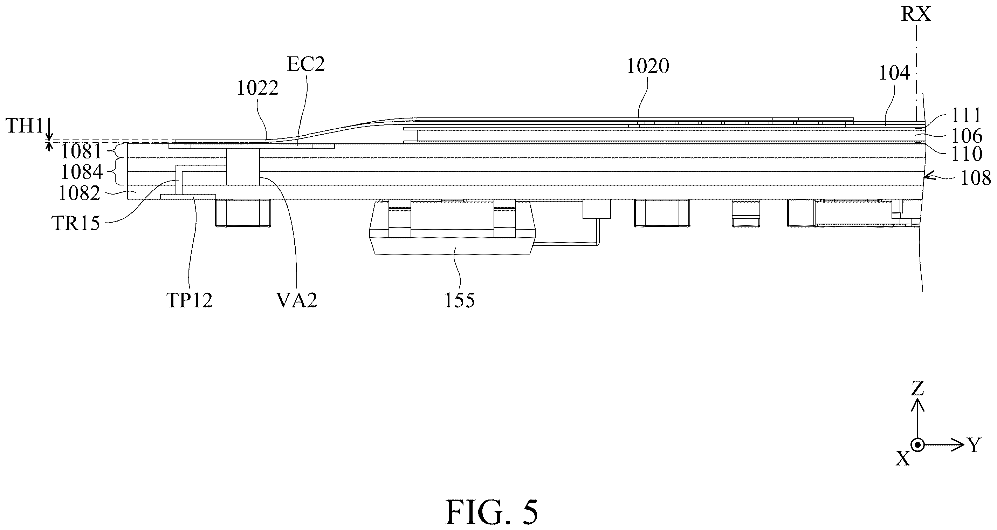

Next, please refer to FIG. 3 to FIG. 5. FIG. 3 is a three-dimensional view of a wireless transmission module 100 according to an embodiment of the present disclosure, FIG. 4 is a bottom view of the wireless transmission module 100 according to an embodiment of the present disclosure, and FIG. 5 is a cross-sectional view of the wireless transmission module 100 along line A-A in FIG. 3 according to an embodiment of the present disclosure. In this embodiment, the wireless transmission module 100 may include a coil assembly 102 and a first base 106. The coil assembly 102 defines a winding axis RX, the first base 106 corresponds to the coil assembly 102, and the coil assembly 102 and the first base 106 are arranged along the winding axis RX.

Furthermore, the wireless transmission module 100 may further include a second base 108 which is configured to carry the coil assembly 102 and the first base 106. The second base 108 has a first side plate 1081 and a second side plate 1082, and the first side plate 1081 is opposite to the second side plate 1082. For example, the first side plate 1081 and the second side plate 1082 are located on opposite sides of the second base 108.

The coil assembly 102 and the first base 106 are disposed on the first side plate 1081. Specifically, the wireless transmission module 100 may further include a first adhesive element 104, a second adhesive element 110, and a protective element 111. The coil assembly 102 is affixed to the first base 106 by the first adhesive element 104 and the protective element 111, and the first base 106 is affixed to the first side plate 1081 of the second base 108 by the second adhesive element 110.

In this embodiment, the first base 106 is configured to change the electromagnetic field distribution near the coil assembly 102. The first base 106 may be a magnetic conductive body, such as a ferrite, but it is not limited thereto. For example, in other embodiments, the first base 106 may also include a nanocrystalline material. The first base 106 may have a magnetic permeability corresponding to the coil assembly 102, so that the electromagnetic waves of the coil assembly 102 are more concentrated.

The first adhesive element 104, the second adhesive element 110, and the protective element 111 may be double-sided adhesive or single-sided adhesive for adhering to one or two adjacent elements. In some embodiments, the first adhesive element 104, the second adhesive element 110, or the protective element 111 may be made of polyethylene terephthalate (PET), but they are not limited thereto. For example, the first adhesive element 104, the second adhesive element 110 and the protective element 111 may also be made of polypropylene (PP).

As shown in FIG. 5, the protective element 111 corresponds to the second adhesive element 110. For example, the protective element 111 and the second adhesive element 110 may have the same size, and the first base 106 is disposed between the second adhesive element 110 and the protective element 111, so that the second adhesive element 110 and the protective element 111 cooperatively cover and protect the first base 106.

For example, as shown in FIG. 3, when viewed along the winding axis RX, the protective element 111 completely shields the first base 106, but it is not limited thereto. In other embodiments, the protective element 111 may also be omitted.

In this embodiment, the coil assembly 102 can serve as a charging coil to be wireless charged by an external charging device. For example, the coil assembly 102 can operate as a resonant charging coil based on the standard of the Alliance for Wireless Power (A4WP), but it is not limited thereto.

In addition, the coil assembly 102 can operate as an inductive charging coil based on the standard of Wireless Power Consortium (WPC), such as the Qi standard. Therefore, the coil assembly 102 can respond to different forms of charging so as to enlarge the range of applications in this embodiment. For example, in the case of a close distance (for example, 1 cm or less), the inductive type operation is used; and at a long distance, a resonance type operation is used.

In this embodiment, the coil assembly 102 can also be used as a communication coil, for example, operating in Near Field Communication (NFC) mode to communicate with external electronic devices.

Similar to the aforementioned embodiment, the wireless transmission module 100 further includes a plurality of electronic components disposed on the second side plate 1082. These electronic components may be resistors 151, inductors 152, capacitors 153, integrated circuit chips 154, transistors 155 or a combination thereof, but they are not limited thereto.

It is also worth noting that these electronic components do not include any coil for wireless transmission. That is, the wireless transmission module 100 has only one single coil assembly 102 disposed on the first side plate 1081, and no coil for wireless transmission is disposed on the second side plate 1082.

As shown in FIG. 3 and FIG. 5, the second base 108 further includes a first electrical contact EC1 and a second electrical contact EC2 which are disposed on the first side plate 1081 and configured to be electrically connected to the coil assembly 102.

As shown in FIG. 3, the coil assembly 102 has a winding body 1020, a first leading wire 1021, and a second leading wire 1022. The first leading wire 1021 and the second leading wire 1022 extend from the winding body 1020 and are configured to be connected to the first electrical contact EC1 and the second electrical contact EC2, respectively.

It is worth noting that the coil assembly 102 can be a pattern coil having a thin structure. Specifically, as shown in FIG. 5, the thickness TH1 of the winding of the coil assembly 102 along the winding axis RX (the Z-axis) is less than 1 mm, for example, 0.38 mm, but it is not limited thereto.

Furthermore, as shown in FIG. 3, a width TW1 of the first leading wire 1021 or the second leading wire 1022 is greater than 1 mm, for example, 1.5 mm or 2 mm, but they are not limited thereto. Based on such a configuration, the overall thickness of the wireless transmission module 100 can be further reduced, thereby achieving the purpose of miniaturization.

Next, in this embodiment, as shown in FIG. 4, the second base 108 can be a printed circuit board, which can include a plurality of traces, which are partially disposed between the first side plate 1081 and the second side plate 1082.

In this embodiment, the second base 108 has a multi-layer structure. For example, as shown in FIG. 5, the first side plate 1081 is the first layer, the second side plate 1082 is, for example, the second layer, and the second base 108 further includes a central layer plate 1084, which is disposed between the first side plate 1081 and the second side plate 1082.

The central layer plate 1084 is, for example, the third layer and the fourth layer, and a portion of these traces is located in the central layer plate 1084. These traces can be distributed in the third layer and the fourth layer or two other layers.

These traces are configured to electrically connect to these electronic components. For example, as shown in FIG. 4, one of the traces TR11 is connected to the integrated circuit chip 154 and the resistor 151, and the other trace TR12 is connected to the integrated circuit chip 154 and the capacitor 153.

It is worth noting that, as shown in FIG. 4, when viewed along the winding axis RX (the Z-axis), a portion of these traces (such as the trace TR12) overlaps a portion of the coil assembly 102, and because the first base 106 is disposed between the coil assembly 102 and these traces, these traces and the coil assembly 102 do not interfere with each other and can operate normally. That is, the first base 106 has the functions of protection and isolation.

Please continue to refer to FIG. 4. In this embodiment, the second base 108 further includes two power input contacts PC1, which are disposed on the second side plate 1082. The two power input contacts PC1 are configured to be electrically connected to one of the electronic components via two of the traces. For example, the two power input contacts PC1 are electrically connected to the inductor 152 via two traces TR13.

In addition, the second base 108 may further include a plurality of detection contacts TP1, which are disposed on the second side plate 1082. These detection contacts TP1 are configured to be electrically connected to at least one of the electronic components. The user can detect whether these electronic components operate normally through the detection contacts TP1.

For example, the detection contacts TP1 can be electrically connected to integrated circuit chip 154 via the traces TR14, so that the user can detect whether integrated circuit chip 154 operates normally through detection contacts TP1.

Furthermore, as shown in FIG. 4 and FIG. 5, the second base 108 further includes a first via VA1 and a second via VA2, and first via VA1 and second via VA2 penetrate the central layer plate 1084.

These detection contacts TP1 can include a first detection contact TP11 and a second detection contact TP12, the first via VA1 is configured to connect to the first electrical contact EC1 and the first detection contact TP11, and the second via VA2 is configured to connect to the second electrical contact EC2 and the second detection contact TP12.

For example, as shown in FIG. 5, the second via VA2 is connected to the second electrical contact EC2, and the second via VA2 is further connected to the second detection contact TP12 via the trace TR15. Therefore, the user can detect the coil assembly 102 via the first detection contact TP11 and the second detection contact TP12.

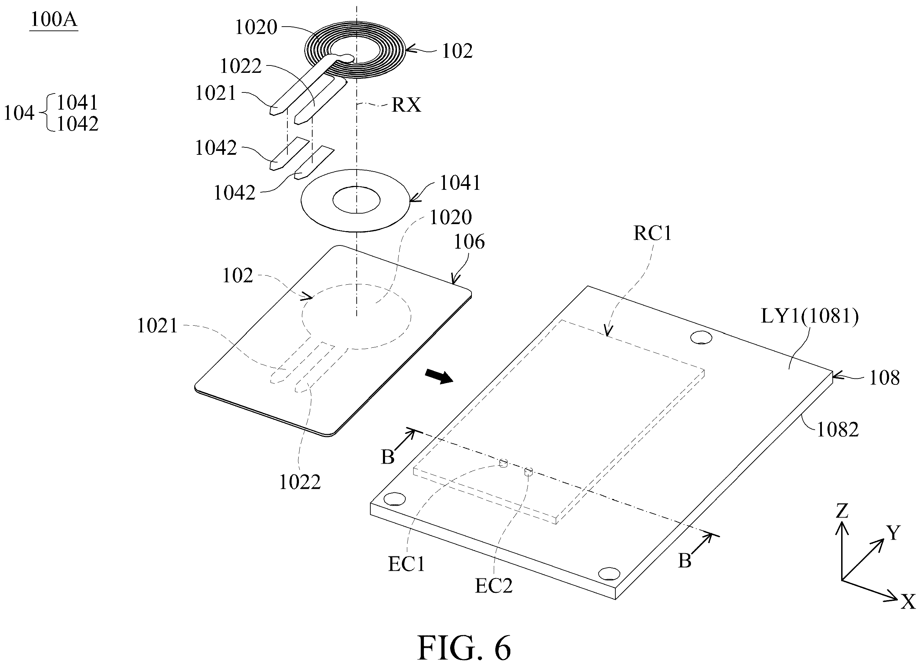

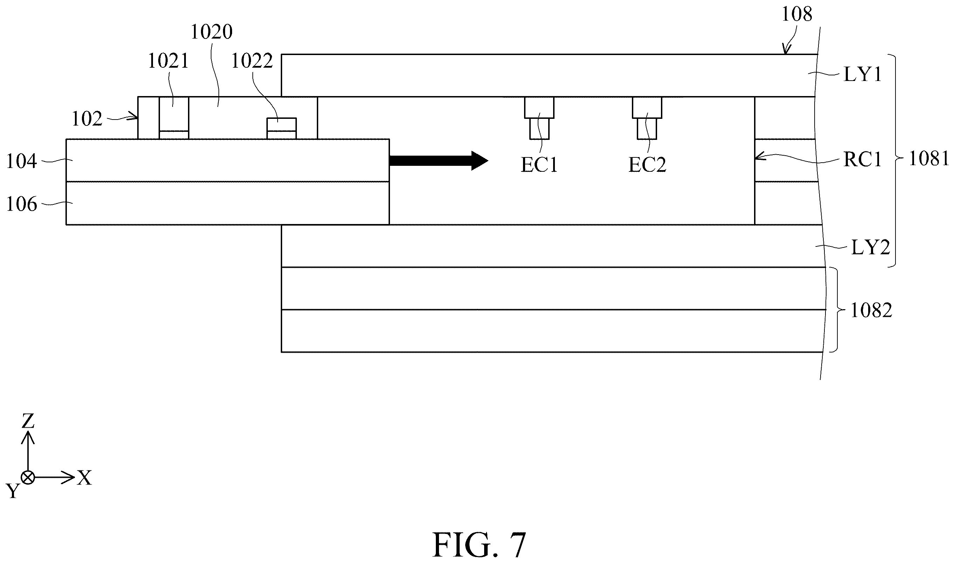

Next, please refer to FIG. 6 and FIG. 7. FIG. 6 is an exploded diagram of a wireless transmission module 100A according to another embodiment of the present disclosure, and FIG. 7 is a cross-sectional view of the wireless transmission module 100A along the line B-B in FIG. 6 according to another embodiment of the present disclosure. In this embodiment, the coil assembly 102, the first adhesive element 104 and the first base 106 are arranged along the winding axis RX in sequence.

It is worth noting that the size of the first base 106 is larger than the size of the coil assembly 102. That is, when viewed along the winding axis RX, the first leading wire 1021 and the second leading wire 1022 completely overlap the first base 106, and the first base 106 is configured to support the first leading wire 1021 and the second leading wire 1022.

The first adhesive element 104 corresponds to the shape of the coil assembly 102. Specifically, in this embodiment, the first adhesive element 104 has a first adhesive portion 1041 and two second adhesive portions 1042. The first adhesive portion 1041 corresponds to the winding body 1020, and the two second adhesive portions 1042 correspond to the first leading wire 1021 and the second leading wire 1022, so that the winding body 1020, the first leading wire 1021 and the second leading wire 1022 are affixed to the first base 106 by the first adhesive element 104.

Similar to the aforementioned embodiment, the second base 108 has a first side plate 1081 and a second side plate 1082, and as shown in FIG. 6 and FIG. 7, the first side plate 1081 may have an accommodating groove RC1 configured to accommodate the coil assembly 102 and the first base 106. The shape of the accommodating groove RC1 corresponds to the shape of the first base 106.

When viewed along the direction of the winding axis RX (the Z-axis), the second base 108 has a rectangular structure. When viewed along the winding axis RX, the rectangular structure has four sides, and the accommodating groove RC1 is disposed on one of the four sides. In this embodiment, the accommodating groove RC1 is disposed on the left side of the second base 108, but it is not limited thereto. For example, in other embodiments, the accommodating groove RC1 is disposed on the right side of the second base 108.

As shown in FIG. 7, the first side plate 1081 has a first layer LY1 and a second layer LY2, at least a portion of the accommodating groove RC1 is located between the first layer LY1 and the second layer LY2, and the first electrical contact EC1 and the second electrical contact EC2 are located in the first side plate 1081.

For example, the first electrical contact EC1 and the second electrical contact EC2 are disposed on the first layer LY1, for example in FIG. 7, disposed at the bottom of the first layer LY1. It is worth noting that, as shown in FIG. 6, when viewed along the winding axis RX, the first electrical contact EC1 and the second electrical contact EC2 are completely shielded by the first layer LY1. That is, the first electrical contact EC1 and the second electrical contact EC2 are buried in the second base 108 and are not exposed from the first layer LY1.

In this embodiment, the first electrical contact EC1 and the second electrical contact EC2 may be pogo pins, but they are not limited thereto. The locations of the first electrical contact EC1 and the second electrical contact EC2 correspond to the first leading wire 1021 and the second leading wire 1022.

In this embodiment, the coil assembly 102, the first adhesive element 104 and the first base 106 are inserted into the accommodating groove RC1 or withdrawn from the accommodating groove RC1 in a detachable manner. When inserted into the accommodating groove RC1, since the first leading wire 1021 and the second leading wire 1022 are supported by the first base 106, the first leading wire 1021 and the second leading wire 1022 can accurately contact the first electrical contact EC1 and the second electrical contact EC2 without any deviation problem.

It should be noted that in addition to the first layer LY1 and the second layer LY2, the first side plate 1081 in this embodiment may further include other layers which are disposed between the first layer LY1 and the second layer LY2. That is, in this embodiment or other embodiments, the number of layers of the first side plate 1081 is not limited to two layers.

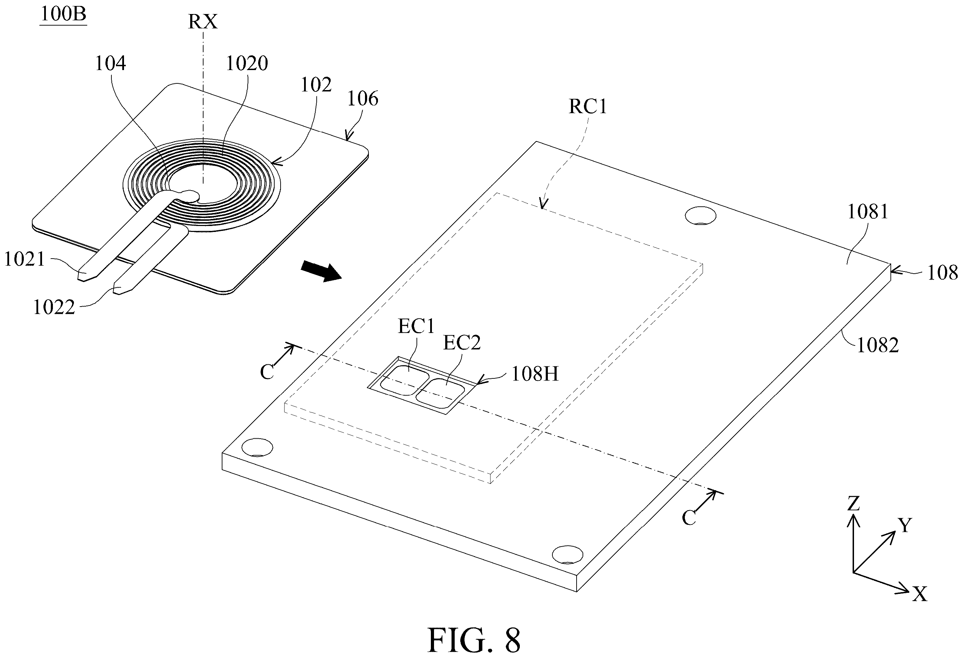

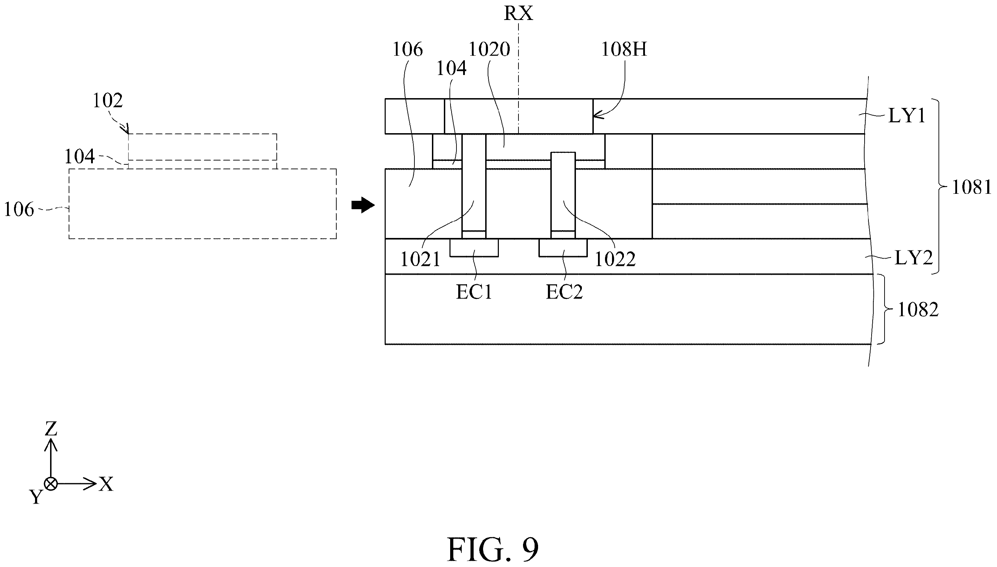

Next, please refer to FIG. 8 and FIG. 9. FIG. 8 is a three-dimensional diagram of a wireless transmission module 100B according to another embodiment of the present disclosure, and FIG. 9 is a cross-sectional view of the wireless transmission module 100B along the line C-C in FIG. 8 according to another embodiment of the present disclosure. The wireless transmission module 100B and the wireless transmission module 100A may have the same elements and a similar configuration.

For example, the shape of the first adhesive element 104 corresponds to the shape of the winding body 1020, so that the winding body 1020 can be fixed to the first base 106 by the first adhesive element 104. In this embodiment, as shown in FIG. 8, when viewed along the winding axis RX, a portion of the first leading wire 1021 and the second leading wire 1022 do not overlap the first base 106.

Furthermore, as shown in FIG. 9, the first electrical contact EC1 and the second electrical contact EC2 are disposed on the second layer LY2. In this embodiment, the first electrical contact EC1 and the second electrical contact EC2 are, for example, metal contacts for welding, but they are not limited thereto.

It is worth noting that, as shown in FIG. 8 and FIG. 9, the second base 108 further has an exposing opening 108H which is formed on the first layer LY1. When observed along the winding axis RX, as shown in FIG. 8, the first electrical contact EC1 and the second electrical contact EC2 are exposed from the exposing opening 108H.

After the coil assembly 102, the first adhesive element 104, and the first base 106 are detachably inserted into the accommodating groove RC1, and when viewed along the winding axis RX, a portion of the first leading wire 1021 and the second leading wire 1022 are also exposed from the exposing opening 108H.

Since the arrangement positions of the first electrical contact EC1 and the second electrical contact EC2 correspond to the first leading wire 1021 and the second leading wire 1022, when viewed along the winding axis RX, the first leading wire 1021 and the second leading wire 1022 overlap a portion of the first electrical contact EC1 and the second electrical contact EC2, respectively.

Based on the above configuration, the operator can conveniently weld the first leading wire 1021 and the second leading wire 1022 through the exposing opening 108H, and since the first leading wire 1021 and the second leading wire 1022 do not protrude from the exposing opening 108H, it can be ensured that the first leading wire 1021 and the second leading wire 1022 do not contact external components and cause damage.

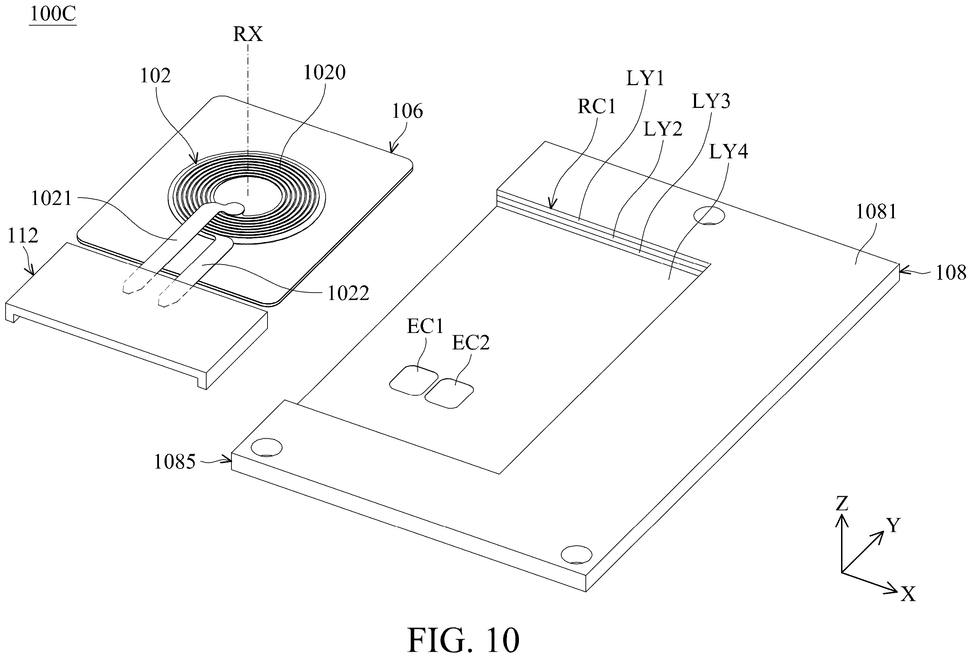

Next, please refer to FIG. 10. FIG. 10 is a three-dimensional diagram of a wireless transmission module 100C according to another embodiment of the present disclosure. The wireless transmission module 100C is similar to the wireless transmission module 100A, for example, the first side plate 1081 has an accommodating groove RC1 configured to accommodate the coil assembly 102 and the first base 106.

In this embodiment, the first side plate 1081 also has a first layer LY1 and a second layer LY2, and the first layer LY1 is directly connected to the second layer LY2. Furthermore, the first side plate 1081 further has a third layer LY3 and a fourth layer LY4, the accommodating groove RC1 is formed in the first layer LY1 to the third layer LY3, and the first electrical contact EC1 and the second electrical contact EC2 are located on the fourth layer LY4.

The accommodating groove RC1 is configured to accommodate the first base 106, the winding body 1020, the first electrical contact EC1, the second electrical contact EC2, the first leading wire 1021, and the second leading wire 1022.

When viewed along the winding axis RX, the second base 108 has a rectangular structure, and when viewed along the winding axis RX, the accommodating groove RC1 is recessed from a side surface 1085 of the rectangular structure.

In addition, when viewed along the winding axis RX, the first electrical contact EC1, the second electrical contact EC2, the first leading wire 1021, and the second leading wire 1022 are exposed from the first layer LY1 so as to facilitate welding of the first leading wire 1021 and the second leading wire 1022.

It is worth noting that in this embodiment, the wireless transmission module 100C may further include a protective element 112. After the first leading wire 1021 and the second leading wire 1022 are welded, the protective element 112 may be disposed in the accommodating groove RC1 to cover the first leading wire 1021 and the second leading wire 1022, thereby ensuring that the first leading wire 1021 and the second leading wire 1022 will not be damaged by collision with external components.

The protective element 112 may be, for example, a single-sided tape or a U-shaped plastic cover, but it is not limited thereto. As long as the shape corresponds to the accommodating groove RC1 and can cover and protect the first leading wire 1021 and the second leading wire 1022 is within the scope of the present disclosure.

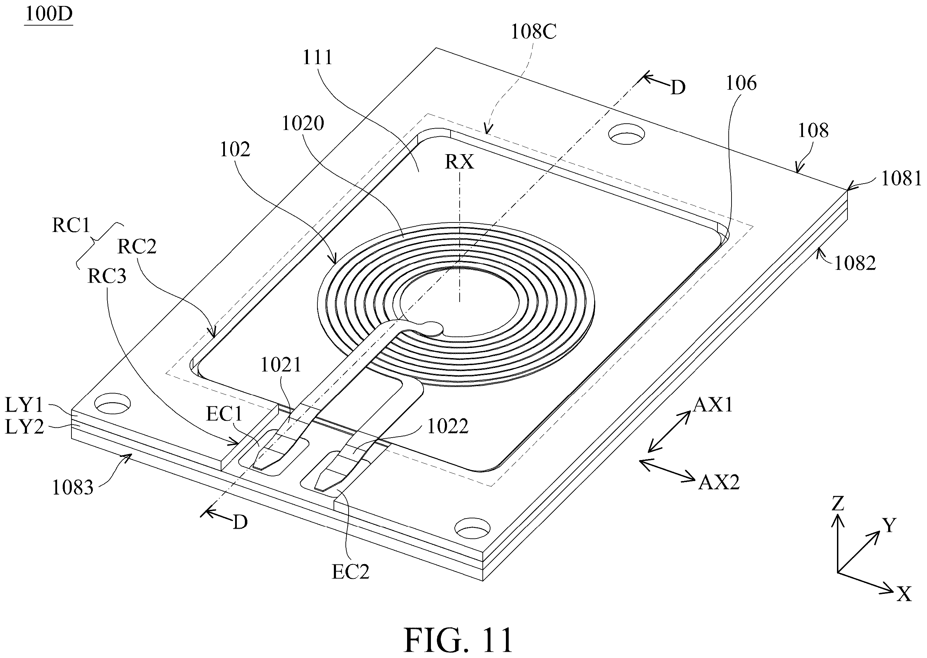

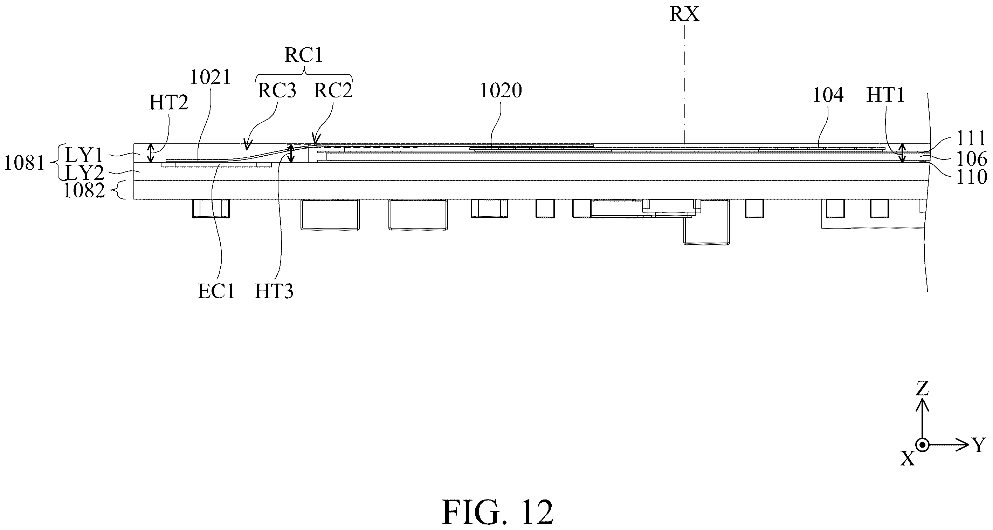

Next, please refer to FIG. 11 and FIG. 12. FIG. 11 is a three-dimensional diagram of a wireless transmission module 100D according to another embodiment of the present disclosure, and FIG. 12 is a cross-sectional view of the wireless transmission module 100D along the line D-D in FIG. 11 according to another embodiment of the present disclosure. The wireless transmission module 100D and the wireless transmission module 100A may have the same elements and a similar configuration.

For example, the shape of the first adhesive element 104 corresponds to the shape of the winding body 1020, so that the winding body 1020 can be fixed to the first base 106 by the first adhesive element 104. In this embodiment, as shown in FIG. 11 and FIG. 12, when viewed along the winding axis RX, a portion of the first leading wire 1021 and the second leading wire 1022 do not overlap the first base 106.

In this embodiment, the first side plate 1081 has an accommodating groove RC1 configured to accommodate the coil assembly 102, the first base 106, the first adhesive element 104, the second adhesive element 110 and the protective element 111. The first base 106 is disposed between the coil assembly 102 and the second base 108.

The first side plate 1081 further has a first layer LY1 and a second layer LY2. Specifically, as shown in FIG. 12, the first layer LY1 is directly connected to the second layer LY2.

The accommodating groove RC1 is formed in the first layer LY1, and a portion of the accommodating groove RC1 has a shape that corresponds to the shape of the first base 106. For example, when viewed along the direction of the winding axis RX, a portion of the accommodating groove RC1 has a rectangular structure.

In this embodiment, the accommodating groove RC1 has a first accommodating portion RC2 and a second accommodating portion RC3, the first accommodating portion RC2 is connected to the second accommodating portion RC3, and the shape of the first accommodating portion RC2 has a rectangular structure.

In this embodiment, the first accommodating portion RC2 is configured to accommodate the first base 106 and the winding body 1020, and the second accommodating portion RC3 is configured to accommodate the first electrical contact EC1, the second electrical contact EC2, the first leading wire 1021, and the second leading wire 1022. As shown in FIG. 11 and FIG. 12, the first electrical contact EC1 and the second electrical contact EC2 are located on the second layer LY2.

As shown in FIG. 11, the second base 108 defines a first axis AX1 and a second axis AX2, the first axis AX1 is perpendicular to the second axis AX2, and the winding axis RX is perpendicular to the first axis AX1 and the second axis AX2. When viewed along the first axis AX1 (the Y-axis), the first leading wire 1021 and the second leading wire 1022 overlap the first layer LY1, and when viewed along the second axis AX2 (the X-axis), the first leading wire 1021 and the second leading wire 1022 also overlap the first layer LY1.

When viewed along the winding axis RX, the second base 108 has a rectangular structure, and the first accommodating portion RC2 is disposed in a central region 108C of the rectangular structure. The winding axis RX passes through the central region 108C and the first accommodating portion RC2.

When viewed along the winding axis RX, the rectangular structure has four sides, and the second accommodating portion RC3 is disposed on one of the four sides. Specifically, when viewed along the winding axis RX, the rectangular structure has a first side 1083, and the second accommodating portion RC3 is located on the first side 1083.

When viewed along the winding axis RX, the first layer LY1 has a horseshoe-shaped structure, and when viewed along the winding axis RX, the shape of the protective element 111 is substantially the same as the shape of the second adhesive element 110, as shown in FIG. 12, and the protective element 111 has a substantially rectangular structure, as shown in FIG. 11.

As shown in FIG. 11, when viewed along the winding axis RX, the second accommodating portion RC3 does not overlap the winding body 1020. The first leading wire 1021 and the second leading wire 1022 extend outward from the winding body 1020 to the first electrical contact EC1 and the second electrical contact EC2, and a portion of the first leading wire 1021 and the second leading wire 1022 is located in the second accommodating portion RC3.

Similarly, in this embodiment, the protective element 111 is disposed between the coil assembly 102 and the first base 106. For example, the protective element 111 is, for example, a plastic sheet, such as being made of PET material, configured to adhere to and protect the first base 106. It should be noted that the configuration of the protective element 111 is not limited to this embodiment, and can be disposed on the first base 106 of the aforementioned wireless transmission module 100A to the wireless transmission module 100C.

Next, in this embodiment, as shown in FIG. 12, the first accommodating portion RC2 has a first depth HT1, the second accommodating portion RC3 has a second depth HT2, and the first depth HT1 is substantially equal to the second depth HT2.

In addition, it is worth noting that the coil assembly 102, the first adhesive element 104, the first base 106, the protective element 111, and the second adhesive element 110 have a total height HT3, and the total height HT3 is less than the first depth HT1. Based on such a configuration, it can be ensured that the winding body 1020 will not be damaged by collision with external components.

Furthermore, it should be noted that for the sake of simplicity, the configurations of the traces, the first via VA1, the second via VA2, and the electronic components are not repeatedly described in the wireless transmission module 100A to the wireless transmission module 100D. In fact, the wireless transmission module 100A to the wireless transmission module 100D may still have the traces, the first via VA1, the second via VA2, and the electronic components and other related configurations similar to those of the wireless transmission module 100.

In conclusion, the present disclosure provides a wireless transmission module 100, which includes a coil assembly 102, a first base 106, and a second base 108. The coil assembly 102 and the first base 106 are disposed on a first side plate 1081 of the second base 108, and a plurality of electronic components are disposed on a second side plate 1082 of the second base 108. Since all electronic components are disposed on the second side plate 1082, the process time of the surface mounting process can be reduced by half, and it is also convenient for the operator to install the coil assembly 102 on the first side plate 1081, thereby increasing the convenience of assembly.

In addition, the second base 108 may be a printed circuit board, and an accommodating groove RC1 may be formed on the first side plate 1081. The accommodating groove RC1 is configured to accommodate the coil assembly 102 and the first base 106. Based on such a configuration, the overall thickness of the wireless transmission module can be greatly reduced to achieve the purpose of thinning.

Furthermore, the coil assembly 102 and the first base 106 are placed into the accommodating groove RC1 or withdrawn from the accommodating groove RC1 in a detachable manner. For example, they are placed into the accommodating groove RC1 from the top surface or a side of the second base 108. Based on such a structural design, a damaged coil assembly 102 can be easily replaced or a coil assembly of the same size but different function can be replaced, so that the same second base 108 can be used, thereby achieving the purpose of reducing the overall production cost.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

Although the embodiments and their advantages have been described in detail, it should be understood that various changes, substitutions, and alterations can be made herein without departing from the spirit and scope of the embodiments as defined by the appended claims. Moreover, the scope of the present application is not intended to be limited to the particular embodiments of the process, machine, manufacture, composition of matter, means, methods, and steps described in the specification. As one of ordinary skill in the art will readily appreciate from the disclosure, processes, machines, manufacture, compositions of matter, means, methods, or steps, presently existing or later to be developed, that perform substantially the same function or achieve substantially the same result as the corresponding embodiments described herein can be utilized according to the disclosure. Accordingly, the appended claims are intended to include within their scope such processes, machines, manufacture, compositions of matter, means, methods, or steps. In addition, each claim constitutes a separate embodiment, and the combination of various claims and embodiments are within the scope of the disclosure.

## Claims

1. A wireless transmission module, comprising:
a coil assembly, having a winding axis; and
a first base, corresponding to the coil assembly;
wherein the coil assembly and the first base are arranged along the winding axis.

2. The wireless transmission module as claimed in claim 1, wherein
the wireless transmission module further includes a second base which is configured to carry the coil assembly and the first base;
the first base is disposed between the coil assembly and the second base;
the second base has a first side plate and a second side plate;
the first side plate is opposite to the second side plate;
at least a portion of the coil assembly and the first base are disposed on the first side plate;
the wireless transmission module further includes a plurality of electronic components which are disposed on the second side plate;
the electronic components include resistors, capacitors, inductors, integrated circuit chips or a combination thereof; and
the electronic components do not include any coil for wireless transmission.

3. The wireless transmission module as claimed in claim 2, wherein
the second base is further provided with a first electrical contact and a second electrical contact;
the coil assembly includes a winding body, a first leading wire and a second leading wire;
the first leading wire and the second leading wire extend from the winding body and are configured to be connected to the first electrical contact and the second electrical contact, respectively;
a thickness of the coil assembly along the winding axis is less than 1 mm; and
a width of the first leading wire or the second leading wire is greater than 1 mm.

4. The wireless transmission module as claimed in claim 3, wherein
the second base further includes a plurality of traces;
at least one of the traces is configured to be electrically connected to two of the electronic components;
when viewed along the winding axis, a portion of the traces overlaps a portion of the coil assembly;
the second base further includes two power input contacts, which are disposed on the second side plate; and
the two power input contacts are configured to be electrically connected to one of the electronic components via two of the traces.

5. The wireless transmission module as claimed in claim 3, wherein
the first side plate has an accommodating groove configured to accommodate the coil assembly and the first base;
the first side plate further has a first layer and a second layer;
at least a portion of the accommodating groove is located between the first layer and the second layer;
a shape of the accommodating groove corresponds to a shape of the first base;
the first electrical contact and the second electrical contact are located in the first side plate;
when viewed along the winding axis, the second base has a rectangular structure;
when viewed along the winding axis, the rectangular structure has four sides; and
the accommodating groove is disposed on one of the four sides.

6. The wireless transmission module as claimed in claim 5, wherein
the first electrical contact and the second electrical contact are disposed on the first layer;
when viewed along the winding axis, the first electrical contact and the second electrical contact are completely shielded by the first layer;
the first electrical contact and the second electrical contact are pogo pins; and
when viewed along the winding axis, the first leading wire and the second leading wire completely overlap the first base.

7. The wireless transmission module as claimed in claim 6, wherein
the wireless transmission module further includes a first adhesive element;
the first adhesive element corresponds to a shape of the coil assembly;
the winding body, the first leading wire, and the second leading wire are fixed to the first base by the first adhesive element; and
the coil assembly, the first adhesive element, and the first base are inserted into or withdrawn from the accommodating groove in a detachable manner.

8. The wireless transmission module as claimed in claim 5, wherein
the first electrical contact and the second electrical contact are disposed on the second layer;
the second base further has an exposing opening which is formed on the first layer;
when viewed along the winding axis, the first electrical contact and the second electrical contact are exposed from the exposing opening;
when viewed along the winding axis, a portion of the first leading wire and the second leading wire are exposed from the exposing opening; and
when viewed along the winding axis, the first leading wire and the second leading wire overlap a portion of the first electrical contact and the second electrical contact, respectively.

9. The wireless transmission module as claimed in claim 8, wherein
the wireless transmission module further includes a first adhesive element, and a shape of the first adhesive element corresponds to a shape of the winding body;
the winding body is fixed to the first base by the first adhesive element; and
when viewed along the winding axis, a portion of the first leading wire and the second leading wire does not overlap the first base.

10. The wireless transmission module as claimed in claim 3, wherein
the first side plate has an accommodating groove configured to accommodate the coil assembly and the first base;
the first side plate further has a first layer and a second layer;
the first layer is directly connected to the second layer;
the first side plate further has a third layer and a fourth layer;
the accommodating groove is formed in the first layer to the third layer;
the first electrical contact and the second electrical contact are located on the fourth layer;
the accommodating groove is configured to accommodate the first base, the winding body, the first electrical contact, the second electrical contact, the first leading wire and the second leading wire;
when viewed along the winding axis, the second base has a rectangular structure; and
when viewed along the winding axis, the accommodating groove is recessed from a side surface of the rectangular structure.

11. The wireless transmission module as claimed in claim 3, wherein
the first side plate has an accommodating groove configured to accommodate the coil assembly and the first base;
the first side plate further has a first layer and a second layer;
the first layer is directly connected to the second layer;
the accommodating groove is formed on the first layer;
a shape of the accommodating groove corresponds to a shape of the first base; and
the first electrical contact and the second electrical contact are located on the second layer.

12. The wireless transmission module as claimed in claim **11,** wherein
the accommodating groove has a first accommodating portion and a second accommodating portion;
the first accommodating portion is connected to the second accommodating portion;
the first accommodating portion is configured to accommodate the first base and the winding body; and
the second accommodating portion is configured to accommodate the first electrical contact, the second electrical contact, the first leading wire and the second leading wire.

13. The wireless transmission module as claimed in claim 12, wherein
the second base defines a first axis and a second axis;
the first axis is perpendicular to the second axis;
the winding axis is perpendicular to the first axis and the second axis;
when viewed along the first axis, the first leading wire and the second leading wire overlap the first layer; and
when viewed along the second axis, the first leading wire and the second leading wire overlap the first layer.

14. The wireless transmission module as claimed in claim 13, wherein
when viewed along the winding axis, the second base has a rectangular structure;
the first accommodating portion is disposed in a central region of the rectangular structure;
the winding axis passes through the central region and the first accommodating portion;
when viewed along the winding axis, the rectangular structure has four sides;
the second accommodating portion is disposed on one of the four sides;
when viewed along the winding axis, the rectangular structure has a first side; and
the second accommodating portion is located on the first side.

15. The wireless transmission module as claimed in claim 14, wherein
when viewed along the winding axis, the first layer has a horseshoe-shaped structure;
when viewed along the winding axis, the second accommodating portion does not overlap the winding body;
the first leading wire and the second leading wire extend outward from the winding body to the first electrical contact and the second electrical contact;
the first accommodating portion has a first depth;
the second accommodating portion has a second depth; and
the first depth is equal to the second depth.
